# EUROPÄISCHE PATENTANMELDUNG

(11) **EP 0 597 313 A1**
(43) Veröffentlichungstag der Anmeldung: **18.05.1994**
(21) Anmeldenummer: 93117313.2
(22) Anmeldetag: 26.10.1993
(51) Int. Cl.: G08G 1/0967

(54) **Verfahren zur Übertragung von Informationen an Verkehrsteilnehmer**

(30) Priorität: 07.11.1992 DE 4237677
(71) Anmelder: ANT Nachrichtentechnik GmbH, D-71522 Backnang (DE)
(72) Erfinder: Lier, Hans-Peter, Dipl.-Ing., D-71546 Aspach (DE); Petry, Hans-Peter, Dr. rer. nat., D-74429 Sulzbach-Laufen (DE)

(57) **Zusammenfassung**

Das Verfahren soll gewährleisten, daß jeder Verkehrsteilnehmer die für ihn bestimmte von Baken ausgesendete Information sicher und möglichst wenig fehlerbehaftet empfängt.

Die ortsfesten Baken senden mit den zu übertragenden Informationen modulierte Trägersignale aus, welche aus bandbegrenztem weißen Rauschen bestehen.

## Beschreibung

Die vorliegende Erfindung betrifft ein Verfahren zur Übertragung von Informationen an Verkehrsteilnehmer, wobei ortsfeste Baken mit den zu übertragenden Informationen modulierte Trägersignale, welche ein Rauschspektrum aufweisen, an die Verkehrsteilnehmer aussenden.

Angesichts des vor allem in Ballungsgebieten auftretenden hohen Straßenverkehrsaufkommens wird es immer dringlicher, den motorisierten Individualverkehr besser zu organisieren mit den Zielen, die natürlichen Ressourcen zu schonen und damit die Umweltbelastung zu reduzieren, die Verkehrssicherheit zu erhöhen, die Wirtschaftlichkeit zu verbessern und die Mobilitätsbedürfnisse der Menschen zu befriedigen.

Einen Beitrag zum Erreichen dieser angestrebten Ziele liefern Verkehrsinformations- und Verkehrsleitsystemen, welche beispielsweise folgende Funktionen aufweisen können:
- Verkehrsdatenerfassung,
- Individuelle Zielführung der Verkehrsteilnehmer,
- Verkehrssicherug, Warnungen,
- Verkehrslagedarstellung,
- Informationen über Stationen und Fahrpläne des öffentlichen Personennahverkehrs,
- Parkrauminformation,
- Flottenmanagementunterstützung/Einsatzleitung,
- Reise- und Touristeninformation,
- Notruf,
- Zugangsberechtigung zu Stadtzentren, Wohngebieten etc.
- Automatische Gebührenerfassung.

Zu einem Verkehrsinformations-Leitsystem gehören am Rande der Straßen installierte Baken, welche an vorbeifahrende mit entsprechenden Sende-/Empfangseinrichtungen ausgestattete Verkehrsteilnehmer Informationen der zuvor genannten Art abgeben.

Insbesondere bei breiten mehrspurigen Straßen reicht eine einzige Bake nicht aus, um allen vorbeifahrenden Verkehrsteilnehmern die gewünschte Information zukommen zu lassen. Denn gerade im Nahbereich des Baken-Strahlungsfeldes können kleinere Fahrzeuge durch größere abgeschattet werden, so daß sie die von der Bake übertragene Information nicht empfangen. Um diesen Nachteil zu vermeiden, werden zwei oder auch mehrere Baken installiert, welche mit ihren Strahlungsfeldern die mehrspurige Straße so ausleuchten, daß die Verkehrsteilnehmer auf jeder Fahrspur individuell die Information erhalten.

Bei mehreren sich teilweise überlappenden Strahlungsfeldern kann es zu Interferenzen kommen, die den Empfang der Informationen auf Seiten der Verkehrsteilnehmer verschlechtern oder sogar ganz unmöglich machen. Um solche Interferenzen weitgehend auszuschließen, werden bei dem einleitend dargelegten, aus der DE 40 35 398 A1 bekannten Verfahren die von den Baken auszusendenden Informationen auf Trägersignale mit rauschähnlichen Spektren aufmoduliert, wobei jede Bake ein Trägersignal mit einem anderen rauschähnlichen Spektrum abstrahlt. Durch diese Maßnahme wird die Kohärenz der einander überlappenden Strahlungsfelder aufgehoben, so daß Interferenzerscheinungen weitgehend vermieden werden. Das rauschähnliche Spektrum wird durch Modulation eines Oszillatorsignals mit einer pn-Folge im Goldcode gebildet. Die Seitenbänder der so modulierten Signale sind korreliert. Miteinander korrelierte Signale können bei Überlagerung aber Interferenzen erzeugen.

Der Erfindung liegt die Aufgabe zugrunde, ein Verfahren der eingangs genannten Art anzugeben, welches gewährleistet, daß jeder Verkehrsteilnehmer die für ihn bestimmte Information sicher und möglichst wenig fehlerbehaftet empfängt.

Erfindungsgemäß wird diese Aufgabe durch die Merkmale des Anspruchs 1 gelöst. Zweckmäßige Ausbildungen des erfundenen Verfahrens und eine vorteilhafte Anordnung zur Durchführung des Verfahrens gehen aus den Unteransprüchen hervor.

Anhand eines in der Zeichnung dargestellten Ausführungsbeispiels wird nun die Erfindung näher erläutert.
Figur 1 zeigt das Prinzipschaltbild einer Baken-Sendeeinrichtung und einer Empfangseinrichtung eines Verkehrsteilnehmers,
Figuren 2a, 2b, 2c zeigen drei Schaltungsbeispiele zum Erzeugen eines Trägersignals mit weißem Rauschen und
Figur 3 zeigt eine Filterschaltung für die Empfangseinrichtung des Verkehrsteilnehmers.

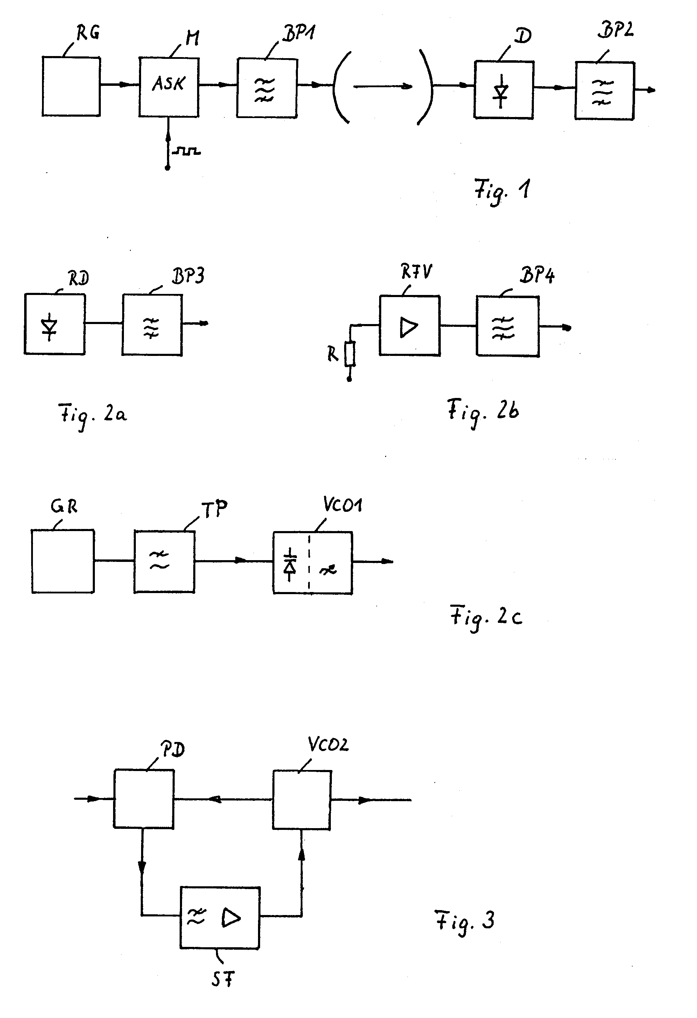

In der Figur 1 ist die Sendeeinrichtung einer Bake dargestellt. Sie setzt sich im wesentlichen zusammen aus einem Generator RG, der ein aus bandbegrenztem weißen Rauschen bestehendes Trägersignal erzeugt, einem die auszusendende Information auf dieses Trägersignal aufmodulierenden Amplituden-Umtast-Modulator (Amplitude shift keying) M und einem anschließenden Bandpaßfilter BP1, welches das auszusendende Spektrum des Nachrichtensignals in seiner Bandbreite begrenzt. Bei weißem Rauschen ist die Rauschleistung über den gesamten Frequenzbereich gleichmäßig verteilt und außerdem sind die darin regellos auftretenden Frequenzen nicht miteinander korreliert. Daher sind aus weißem Rauschen bestehende Bakenträgersignale äußerst unempfindlich für Interferenzerscheinungen.

Um die von der Bake übertragene Information auf der Seite des Verkehrsteilnehmers wiedergewinnen zu können, besitzt dessen Empfangseinrichtung beispielsweise einen Hüllkurvendetektor D und ein Bandpaßfilter BP2, das das demodulierte Nachrichtensignal filtert.

Eine sehr einfache Ausführung eines Generators RG, der das aus weißem Rauschen bestehende Trägersignal erzeugt, besteht - wie Fig. 1 zeigt - aus einer Rauschdiode RD und einem nachfolgenden schmalbandigen Bandpaß BP3, der auf die Sendefrequenz (z.B. 5,8 GHz) abgestimmt ist.

Eine weitere Ausführung des Generators RG besteht aus einem mit einem reellen Widerstand R abgeschlossenen Hochfrequenzverstärker RFV, dessen Verstärkung so gewählt ist, daß die durch einen abschließenden Bandpaß BP4 bandbegrenzte Rauschleistung der geforderten Sendeleistung entspricht. Die Mittenfrequenz des Verstärkers RFV entspricht der Sendefrequenz (z.B. 5,8 GHz). Eine vorteilhafte Variante dieser Ausführung besteht darin, daß das Bandpaßverhalten des Rauschgenerators RG durch eine entsprechende Struktur der Koppelnetzwerke zwischen den einzelnen Stufen des Hochfrequenzverstärkers RFV erreicht wird.

Eine andere einfache Ausführung eines Generators RG, der das aus bandbegrenztem weißen Rauschen bestehende Trägersignal erzeugt, ist der Figur 2c zu entnehmen. Der Generator RG ist ein spannungsgesteuerter Oszillator VC01, dessen Steuerspannung von einem Rauschgenerator GR mit Tiefpaß TP kommt. Die Frequenz des Rauschgenerators GR liegt erheblich niedriger (z.B. 0 ... 0,5 MHz) als die Mittenfrequenz (z.B. 5,8 GHz) des spannungsgesteuerten Oszillators VC01.

Die Bandbreite und die Form des durch Frequenzmodulation entstandenen Trägersignalspektrums lassen sich durch Wahl des Modulationsindexes und des Frequenzhubes einstellen.

Durch Ankopplung des durch den Tiefpaß TP begrenzten niederfrequenten Rauschsignals an eine Varaktordiode des spannungsgesteuerten Oszillators VC01 wird dieser frequenzmoduliert, wobei der Pegel des vom Rauschgenerator GR erzeugten Rauschsignals den Frequenzhub des frequenzmodulierten Signals bestimmt. Durch Wahl der Grenzfrequenz des Tiefpasses TP und des Frequenzhubes wird der Modulationsindex festgelegt, der die Verteilung der Energie auf den Träger und die Seitenbänder vorgibt. Die Bandbreite und die Pegel von Träger und Seitenbändern können damit so dimensioniert werden, daß Interferenzen nicht auftreten.

Wie die Figur 3 zeigt, kann das schmalbandige Bandpaßfilter BP2 in der Empfangseinrichtung des Verkehrsteilnehmers ein Phasenregelkreis (PLL) sein, der in bekannter Weise aus einem Phasendiskriminator PD, einem spannungsgesteuerten Oszillator VC02 und einem Regelfilter RF mit Verstärker besteht.

## Patentansprüche

1. Verfahren zur Übertragung von Informationen an Verkehrsteilnehmer, wobei ortsfeste Baken mit den zu übertragenden Informationen modulierte Trägersignale, welche ein Rauschspektrum aufweisen, an die Verkehrsteilnehmer aussenden, dadurch gekennzeichnet, daß als Trägersignale bandbegrenzte Signale weißen Rauschens verwendet werden.

2. Verfahren nach Anspruch 1, dadurch gekennzeichnet, daß das Trägersignal durch Frequenzmodulation eines Hochfrequenzsignals mit einem Rauschsignal gebildet wird.

3. Verfahren nach Anspruch 2, dadurch gekennzeichnet, daß die Bandbreite und Form des Trägersignal-Spektrums durch Wahl des Frequenzmodulationsindexes und/oder des Frequenzhubes eingestellt wird.

4. Anordnung zum Durchführen des Verfahrens nach Anspruch 1 oder 2 dadurch gekennzeichnet, daß ein spannungsgesteuerter Oszillator (VC01) dessen Steuerspannung ein Rauschgenerator (GR) liefert, das bandbegrenzte Rauschsignal erzeugt.

5. Anordnung zum Durchführen des Verfahrens nach Anspruch 1, dadurch gekennzeichnet, daß eine Rauschdiode (RD) und ein daran angeschlossener Bandpaß (BP3) das bandbegrenzte Signal weißen Rauschens erzeugen.

6. Anordnung zum Durchführen des Verfahrens nach Anspruch 1, dadurch gekennzeichnet, daß ein mit einem reellen Widerstand (R) abgeschlossener Hochfrequenzverstärker (RFV) und ein daran angeschlossener Bandpaß (BP3) das bandbegrenzte Signal weißen Rauschens erzeugen.
